# EUROPEAN PATENT APPLICATION

(11) **EP 4 766 146 A1**
(43) Date of publication of application: **24.06.2026**
(21) Application number: 25209831.4
(22) Date of filing: 20.10.2025
(51) Int. Cl.: H10W 72/20, H10W 72/29, H10W 72/00, H10W 90/00, H10W 70/60, H10W 70/685, H10W 72/90

(54) **SEMICONDUCTOR PACKAGE INCLUDING AN ELECTRODE**

(30) Priority: 19.12.2024 KR 20240191559
(71) Applicant: SK hynix Inc., Bubal-eub Icheon-si Gyeonggi-do 17336 (KR)
(72) Inventor: JUNG, Sung Mok, Icheon-si, Gyeonggi-do (KR)
(74) Representative: Isarpatent

(57) **Abstract**

The present application relates to a semiconductor package. The semiconductor package includes a wiring structure. The wiring structure includes a first insulating layer, a conductive pad on the first insulating layer, a second insulating layer on the conductive pad, a through hole passing through the second insulating layer and overlapping with the conductive pad, a protruding pattern disposed on the conductive pad and located in the through hole, and an under bump metallurgy (UBM) layer that contacts the upper surface and side surface of the protruding pattern and is connected to the conductive pad. A semiconductor chip connected to the UBM layer and disposed on the wiring structure.

## Description

### BACKGROUND

### 1. Technical Field

Embodiments of the present disclosure generally relate to a semiconductor package, and more particularly, to a semiconductor package including electrodes and a method of forming the semiconductor package including the electrodes.

### 2. Related Art

In response to the miniaturization of semiconductor packages, the technology of mounting semiconductor chips on substrates including wirings is becoming increasingly difficult. The semiconductor chips may be electrically connected to the wirings in the substrates through conductive interconnections. The coupling between the conductive interconnections and neighboring components affects the electrical characteristics and reliability of the semiconductor packages.

### SUMMARY

In an embodiment, a semiconductor package may include a wiring structure. The wiring structure may include a first insulating layer, a conductive pad on the first insulating layer, a second insulating layer on the conductive pad, a through hole passing through the second insulating layer and overlapping with the conductive pad, a protruding pattern disposed on the conductive pad and located in the through hole, and an under bump metallurgy (UBM) layer that contacts the upper surface and side surface of the protruding pattern and is connected to the conductive pad. A semiconductor chip connected to the UBM layer and disposed on the wiring structure.

In an embodiment, a semiconductor package may include a wiring structure. The wiring structure may include a first insulating layer, a plurality of conductive pads on the first insulating layer, a second insulating layer on the plurality of conductive pads, a plurality of through holes that pass through the second insulating layer and overlap the plurality of conductive pads, a plurality of protruding patterns respectively disposed on the plurality of conductive pads and respectively located in the plurality of through holes, and a plurality of UBM layers that respectively contact the upper surfaces and side surfaces of the plurality of protruding patterns and are connected to the plurality of conductive pads. First and second semiconductor chips may be disposed on the wiring structure. An encapsulation layer that covers the first and second semiconductor chips may be disposed on the wiring structure.

In an embodiment, a semiconductor package may include a conductive pad on a first insulating layer. A second insulating layer may be disposed on the conductive pad. A through hole that passes through the second insulating layer and overlaps the conductive pad may be disposed. A protruding pattern that has a horizontal width smaller than the through hole may be disposed on the conductive pad and located in the through hole. A UBM layer that contacts the upper surface and side surface of the protruding pattern and has a horizontal width larger than the through hole may be disposed. The upper surface of the UBM layer may have a concave area that overlaps a space between the protruding pattern and the second insulating layer. A semiconductor chip may be disposed on the UBM layer.

### BRIEF DESCRIPTION OF THE DRAWINGS

FIG. 1 is a cross-sectional view illustrating a semiconductor package according to embodiments of the present disclosure.
FIG. 2 is an embodiment of a partial cross-sectional view illustrating a part of FIG. 1.
FIG. 3 and FIG. 4 are cross-sectional views illustrating partial configurations of semiconductor packages according to embodiments of the present disclosure.
FIG. 5 and FIG. 6 are perspective views illustrating a partial configuration of a semiconductor package according to embodiments of the present disclosure.
FIG. 7 and FIG. 8 are cross-sectional views illustrating semiconductor packages according to embodiments of the present disclosure.
FIG. 9 to FIG. 19 are cross-sectional views illustrating a method of forming a semiconductor package according to embodiments of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," "under," or "beneath" another element, the elements may directly contact each other or an intervening element may be disposed between the elements.

Terms such as "vertical," "horizontal," "top," "bottom," "above," "below," "under," "beneath," "over," "on," "side," "upper," "uppermost," "lower," "lowermost," "front," "rear," "left," "right," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.
Embodiments of the present disclosure are directed to providing a semiconductor package including electrodes and a method of forming the same.
According to embodiments of the present disclosure, a semiconductor package including electrodes and a method of forming the same may be provided.

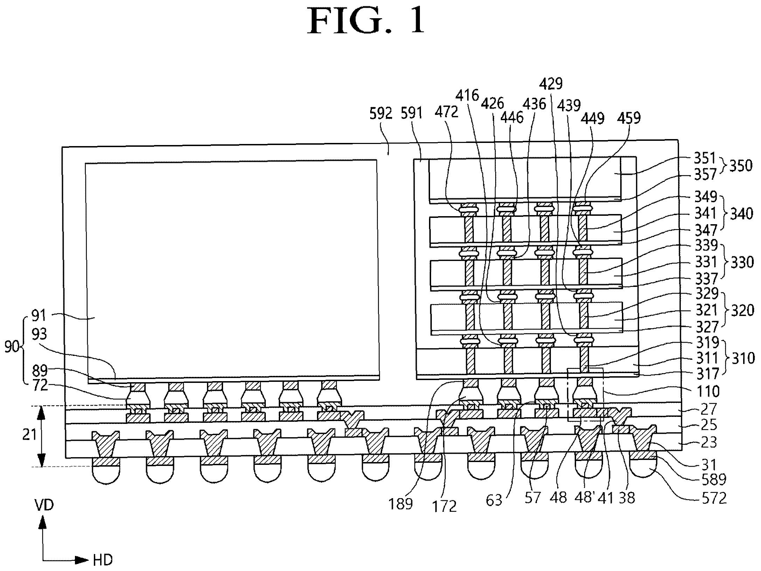

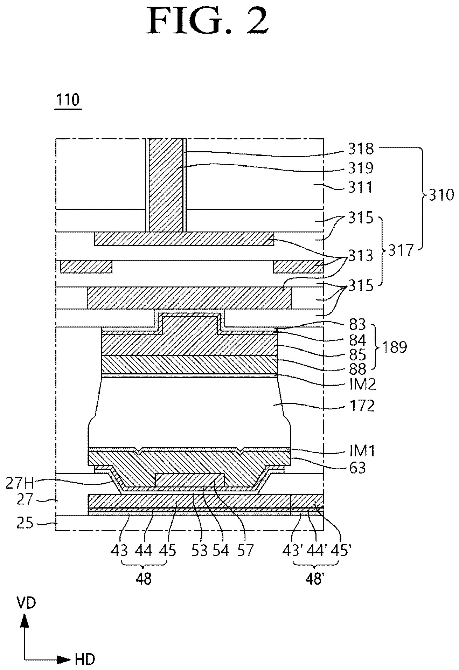

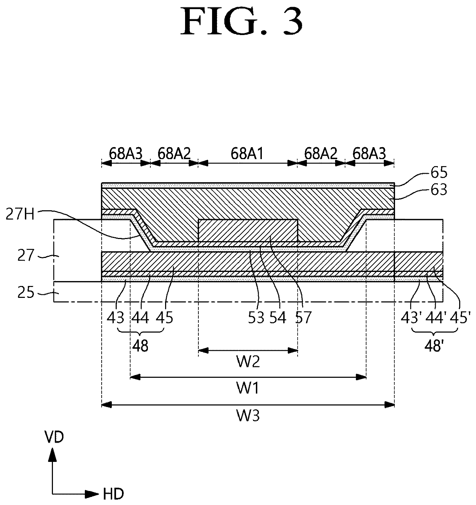

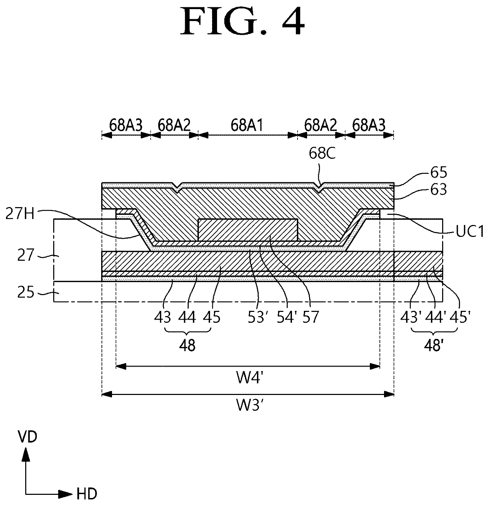

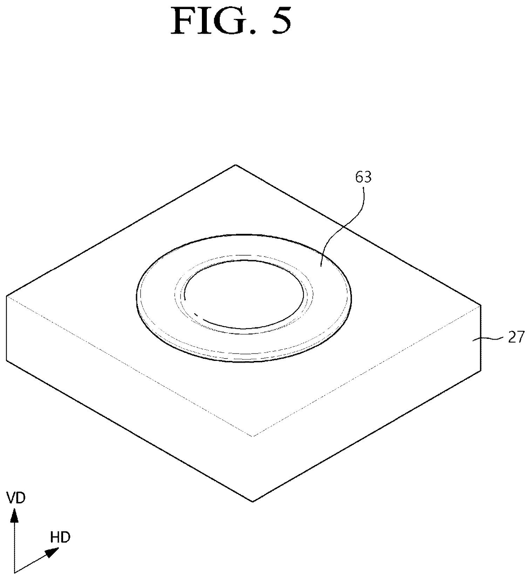

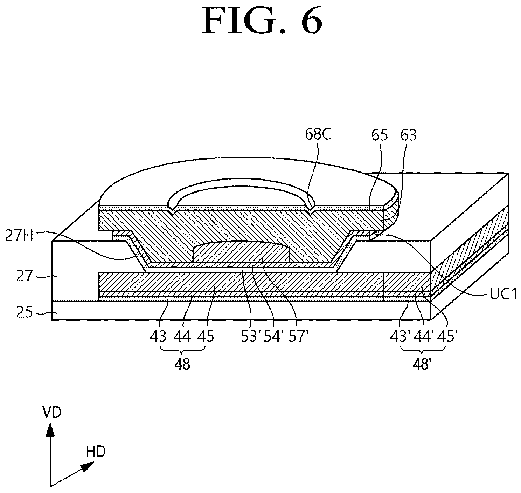

FIG. 1 is a cross-sectional view illustrating a semiconductor package according to embodiments of the present disclosure. FIG. 2 is an embodiment of a partial cross-sectional view illustrating a part 110 of FIG. 1. FIG. 3 and FIG. 4 are cross-sectional views illustrating partial configurations of semiconductor packages according to embodiments of the present disclosure. FIG. 5 and FIG. 6 are perspective views illustrating a partial configuration of a semiconductor package according to embodiments of the present disclosure.

Referring to FIG. 1, a semiconductor package according to embodiments of the present disclosure may include a wiring structure 21, a first semiconductor chip 90, a base chip 310, core chips 320, 330 and 340, a top chip 350, an external solder interconnection 572, a first encapsulation layer 591, and a second encapsulation layer 592.

The wiring structure 21 may include a first insulating layer 23, a second insulating layer 25, a third insulating layer 27, a first via electrode 31, a first horizontal electrode 38, a second via electrode 41, a conductive pad 48, a second horizontal electrode 48', a protruding pattern 57, an under bump metallurgy (UBM) layer 63, and an external electrode 589. In an embodiment, the wiring structure 21 may include an Si-less interposer (SLIP) or a redistribution layer (RDL) substrate.

The first insulating layer 23, the second insulating layer 25, and the third insulating layer 27 may be sequentially stacked. The first via electrode 31 may penetrate the first insulating layer 23 in a vertical direction VD. The first horizontal electrode 38 may be disposed between the first insulating layer 23 and the second insulating layer 25. The first via electrode 31 may contact a side surface of the first horizontal electrode 38. The vertical direction VD is perpendicular to an upper surface of the wiring structure 21. A horizontal direction HD is one of the directions that are parallel to the upper surface of the wiring structure 21.

The second via electrode 41 may penetrate the second insulating layer 25 in the vertical direction VD and contact the first horizontal electrode 38. The conductive pad 48 and the second horizontal electrode 48' may be disposed between the second insulating layer 25 and the third insulating layer 27. The second horizontal electrode 48' may contact the second via electrode 41. The conductive pad 48 may contact the side surface of the second horizontal electrode 48'.

The protruding pattern 57 may be disposed on the conductive pad 48. The UBM layer 63 may be disposed on the conductive pad 48 and the protruding pattern 57. A first solder interconnection 72 may be disposed on the UBM layer 63. The UBM layer 63 and the protruding pattern 57 will be described again with reference to FIG. 2 to FIG. 6.

The first semiconductor chip 90 may be mounted on the wiring structure 21. The first semiconductor chip 90 may include the first solder interconnection 72, a chip electrode 89, a first substrate 91, and a first circuit layer 93. The first circuit layer 93 may be disposed on the lower surface of the first substrate 91. The chip electrode 89 may be disposed on the lower surface of the first circuit layer 93. The first solder interconnection 72 may be disposed between the UBM layer 63 and the chip electrode 89.

The base chip 310, the core chips 320, 330 and 340, the top chip 350, and the first encapsulation layer 591 may constitute a multi-chip package. In an embodiment, the base chip 310, the core chips 320, 330 and 340, the top chip 350, and the first encapsulation layer 591 may be a high bandwidth memory (HBM) package. The base chip 310 may include a base substrate 311, a base circuit layer 317, and a base through electrode 319. The base circuit layer 317 may be disposed on the lower surface of the base substrate 311. The base through electrode 319 may penetrate the base substrate 311 in the vertical direction VD and be connected to the base circuit layer 317. In an embodiment, each of the base chip 310, the core chips 320, 330 and 340, and the top chip 350 may be a semiconductor chip.

The core chips 320, 330 and 340 may include a first core chip 320, a second core chip 330, and a third core chip 340. The first core chip 320 may include a first core substrate 321, a first core circuit layer 327, and a first core through electrode 329. The first core circuit layer 327 may be disposed on the lower surface of the first core substrate 321. The first core through electrode 329 may penetrate the first core substrate 321 in the vertical direction VD and be connected to the first core circuit layer 327.

The second core chip 330 may include a second core substrate 331, a second core circuit layer 337, and a second core through electrode 339. The second core circuit layer 337 may be disposed on the lower surface of the second core substrate 331. The second core through electrode 339 may penetrate the second core substrate 331 in the vertical direction VD and be connected to the second core circuit layer 337.

The third core chip 340 may include a third core substrate 341, a third core circuit layer 347, and a third core through electrode 349. The third core circuit layer 347 may be disposed on the lower surface of the third core substrate 341. The third core through electrode 349 may penetrate the third core substrate 341 in the vertical direction VD and be connected to the third core circuit layer 347.

The top chip 350 may include a top substrate 351 and a top circuit layer 357. The top circuit layer 357 may be disposed on the lower surface of the top substrate 351.

The core chips 320, 330 and 340 may be sequentially stacked on the base chip 310. The top chip 350 may be stacked on an uppermost core chip. In an embodiment, the top chip 350 may be stacked on the third core chip 340. The first encapsulation layer 591 may cover the base chip 310, the core chips 320, 330 and 340 and the top chip 350. The first encapsulation layer 591 may extend between the base chip 310, the core chips 320, 330 and 340, and the top chip 350. The upper surface of the first encapsulation layer 591 and the upper surface of the top chip 350 may form substantially the same plane. In an embodiment, one another core chip or a plurality of other core chips may be additionally stacked between the base chip 310 and the first core chip 320, between the core chips 320, 330 and 340 and between the third core chip 340 and the top chip 350 In FIG. 1, three core chips 320, 330, and 340 are arranged between the base chip 310 and the top chip 350, but the present disclosure is not limited thereto. One or more core chips may be arranged between the base chip and the top chip.

The base chip 310 may include a base back electrode 416. The base back electrode 416 may be disposed on the upper surface of the base substrate 311. The base back electrode 416 may overlap the base through electrode 319. The base back electrode 416 may be contacts the upper end of the base through electrode 319. A first core front electrode 429 may be disposed on the lower surface of the first core circuit layer 327. A second solder interconnection 472 may be disposed between the base back electrode 416 and the first core front electrode 429.

The first core chip 320 may include a first core back electrode 426. The first core back electrode 426 may be disposed on the upper surface of the first core substrate 321. The first core back electrode 426 may overlap the first core through electrode 329. The first core back electrode 426 may contact the upper end of the first core through electrode 329. A second core front electrode 439 may be disposed on the lower surface of the second core circuit layer 337. A second solder interconnection 472 may be disposed between the first core back electrode 426 and the second core front electrode 439.

The second core chip 330 may include a second core back electrode 436. The second core back electrode 436 may be disposed on the upper surface of the second core substrate 331. The second core back electrode 436 may overlap the second core through electrode 339. The second core back electrode 436 may contact the upper end of the second core through electrode 339. A third core front electrode 449 may be disposed on the lower surface of the third core circuit layer 347. A second solder interconnection 472 may be disposed between the second core back electrode 436 and the third core front electrode 449.

The third core chip 340 may include a third core back electrode 446. The third core back electrode 446 may be disposed on the third core substrate 341. The third core chip 340 may overlap the third core through electrode 349. The third core back electrode 446 may contact the upper end of the third core through electrode 349. A top front electrode 459 may be disposed on the lower surface of the top circuit layer 357. A second solder interconnection 472 may be disposed between the third core back electrode 446 and the top front electrode 459.

The base chip 310 may include a base chip electrode 189. The base chip electrode 189 may be disposed on the lower surface of the base circuit layer 317. A third solder interconnection 172 may be disposed between the UBM layer 63 and the base chip electrode 189.

Although not illustrated, in an embodiment, the second solder interconnections 472 may be omitted. The first core front electrode may contact the base back electrode. The second core front electrode may contact the first core back electrode. The third core front electrode may contact the second core back electrode. The top front electrode may contact the third core back electrode. The base chip, the core chips and the top chip may be connected using hybrid bonding technology.

The second encapsulation layer 592 may cover the wiring structure 21, the first semiconductor chip 90, the base chip 310, the core chips 320, 330 and 340, the top chip 350, and the first encapsulation layer 591. The second encapsulation layer 592 may extend between the wiring structure 21 and the first semiconductor chip 90 and between the wiring structure 21 and the base chip 310. In an embodiment, the second encapsulation layer 592 may directly contact the side surfaces of the UBM layer 63, the first solder interconnection 72, the chip electrode 89, the third solder interconnection 172 and the base chip electrode 189.

The wiring structure 21 may include the external electrode 589. The external electrode 589 may be disposed on the lower surface of the first insulating layer 23. The external electrode 589 may overlap the first via electrode 31. The external electrode 589 may be connected to the first via electrode 31. The external solder interconnection 572 may be disposed on the external electrode 589.

In an embodiment, the first semiconductor chip 90 may include a graphic processing unit, a controller, an application processor, a microprocessor, or a combination thereof. The base chip 310 may include a logic circuit. In an embodiment, the base chip 310 may include a silicon through electrode such as the base through electrode 319. The base chip 310 may serve to control the memory included in the core chips 320, 330 and 340. The base chip 310 may perform computations. The core chips 320, 330 and 340 and the top chip 350 may include volatile memory, nonvolatile memory, or a combination thereof. The top chip 350 may include a dummy chip.

Referring to FIG. 2, the conductive pad 48 and the second horizontal electrode 48' may be disposed on the second insulating layer 25. The conductive pad 48 and the second horizontal electrode 48' may include first barrier layers 43 and 43', first seed layers 44 and 44' and first conductive layers 45 and 45' that are sequentially stacked. The first seed layers 44 and 44' and the first conductive layers 45 and 45' may be composed of the same material. In this case, the boundaries between the first seed layers 44 and 44' and the first conductive layers 45 and 45' may be difficult to be recognized. Although not illustrated, in an embodiment, the first seed layers 44 and 44' may be omitted. The third insulating layer 27 may be disposed on the second insulating layer 25, the conductive pad 48, and the second horizontal electrode 48'. The third insulating layer 27 may cover the second insulating layer 25, the conductive pad 48 and the second horizontal electrode 48'.A through hole 27H may be disposed to extend through the third insulating layer 27. The through hole 27H may overlap the conductive pad 48.

A second barrier layer 53 may be disposed to conformally cover the bottom and sidewall of the through hole 27H. The second barrier layer 53 may further extend onto the third insulating layer 27. The second barrier layer 53 may contact the first conductive layer 45 of the conductive pad 48. The second barrier layer 53 may contact the side surface and upper surface of the third insulating layer 27. A second seed layer 54 may be disposed on the second barrier layer 53.

The protruding pattern 57 may be disposed on the second seed layer 54.The protruding pattern 57 may overlap the center of the through hole 27H. The uppermost surface of the protruding pattern 57 may be at substantially the same level as, or lower than, the uppermost surface of the third insulating layer 27.

The UBM layer 63 may be disposed on the second seed layer 54 and the protruding pattern 57. A UBM layer 63 may be disposed such that it fills the through hole 27H and extends onto the third insulating layer 27. The UBM layer 63 may cover the upper surface and side surface of the protruding pattern 57. The UBM layer 63 may overlap the conductive pad 48. The upper surface of the UBM layer 63 may be disposed at a higher level than the uppermost surface of the third insulating layer 27.

The base chip 310 may include the base substrate 311, the base circuit layer 317, an insulating spacer 318, and the base through electrode 319. The base circuit layer 317 may be disposed on the lower surface of the base substrate 311. The base circuit layer 317 may include a plurality of conductive patterns 313 and a plurality of circuit insulating layers 315. The plurality of conductive patterns 313 may include chip pads. The base through electrode 319 penetrate the base substrate 311 in the vertical direction VD. The plurality of conductive patterns 313 may be connected to the conductive pattern 313. The insulating spacer 318 may surround the side surface of the base through electrode 319. The base through electrode 319 may be insulated from the base substrate 311 by the insulating spacer 318.

The base chip 310 may include the base chip electrode 189 that is disposed on the lower surface of the base circuit layer 317. The base chip electrode 189 may penetrate the circuit insulating layer 315 and be connected to the conductive pattern 313. In an embodiment, the base chip electrode 189 may include a third barrier layer 83, a third seed layer 84, a second conductive layer 85 and a third conductive layer 88 that are sequentially stacked.

The third solder interconnection 172 may be disposed between the UBM layer 63 and the base chip electrode 189. A first intermetallic layer IM1 may be disposed between the UBM layer 63 and the third solder interconnection 172. A second intermetallic layer IM2 may be disposed between the third solder interconnection 172 and the base chip electrode 189.

According to embodiments of the present disclosure, the protruding pattern 57 is configured to reduce topographical variations of the upper surface of the UBM layer 63. In an embodiment, the topographical variations of the UBM layer 63 may be minimized by the protruding pattern 57. The protruding pattern 57 may enable the upper surface of the central area of the UBM layer 63 to be at the same or a similar level as that of the edge area. This can reduce the height difference across the UBM layer 63. In an embodiment, the formation of defects such as voids between the third solder interconnection 172 and the UBM layer 63 may be prevented or reduced. In an embodiment, a reliable mechanical and/or electrical coupling may be achieved between the third solder interconnection 172 and the UBM layer 63.

In an embodiment, each of the first circuit layer 93 (see FIG. 1), the first core circuit layer 327 (see FIG. 1), the second core circuit layer 337 (see FIG. 1), the third core circuit layer 347 (see FIG. 1) and the top circuit layer 357 (see FIG. 1) may include substantially the same components as the plurality of conductive patterns 313 and the plurality of circuit insulating layers 315.

Referring to FIG. 3, The lower end of the through hole 27H may have a smaller horizontal width than the upper end of the through hole 27H. The through hole 27H may have a wider opening at the top and a narrower portion at the bottom, which defines an inverted trapezoidal cross-sectional shape. The through hole 27H may have an inclined sidewall, which is defined by an inclined side surface of the third insulating layer 27.

In an embodiment, the second barrier layer 53 may be disposed between the conductive pad 48 and a protruding pattern 57. The second barrier layer 53 may extend on the conductive pad 48 between the third insulating layer 27 and the protruding pattern 57. The second barrier layer 53 may overlap the conductive pad 48.

The protruding pattern 57 may be disposed on the second seed layer 54 in the through hole 27H. The protruding pattern 57 may have a horizontal width smaller than the through hole 27H. The horizontal width of the through hole 27H is W1. The horizontal width of the protruding pattern 57 is W2. W2 is smaller than W1. The protruding pattern 57 may have a horizontal width smaller than the second seed layer 54. The protruding pattern 57 may have a horizontal width smaller than the second barrier layer 53. Each of the horizontal width of the second barrier layer 53 and the horizontal width of the second seed layer 54 is W3. W2 is smaller than W3.

The horizontal width of the UBM layer 63 may be larger than the horizontal width of the through hole 27H. The horizontal width of the UBM layer 63 is W3. W3 is larger than W1. The UBM layer 63 may fill the space between the sidewall of the through hole 27H and the protruding pattern 57. The UBM layer 63 may contact the second seed layer 54 in a region between the sidewall of the through hole 27H and the protruding pattern 57. The protruding pattern 57 may help reduce topographical variations on the upper surface of the UBM layer 63. As a result, the UBM layer 63 may have a substantially flat upper surface.

A capping layer 65 may be disposed on the UBM layer 63. The capping layer 65 may have a thickness smaller than the UBM layer 63. The capping layer 65 may conformally cover the UBM layer 63. In an embodiment, the capping layer 65 may be omitted. The second barrier layer 53 and the second seed layer 54 may be disposed between the conductive pad 48 and the protruding pattern 57. The second barrier layer 53 and the second seed layer 54 may be disposed between the conductive pad 48 and the UBM layer 63. The second barrier layer 53 and the second seed layer 54 may be disposed between the third insulating layer 27 and the UBM layer 63.

In an embodiment, the UBM layer 63 may include a first section 68A1, a second section 68A2 and a third section 68A3. The first section 68A1 of the UBM layer 63 may overlap the protruding pattern 57. The first section 68A1 of the UBM layer 63 may overlap the center of the through hole 27H. The second section 68A2 of the UBM layer 63 may overlap the space between the third insulating layer 27 and the protruding pattern 57. The second section 68A2 of the UBM layer 63 does not overlap the third insulating layer 27. The second section 68A2 of the UBM layer 63 may be continuous to the outside of the first section 68A1 of the UBM layer 63. The third section 68A3 of the UBM layer 63 may overlap the third insulating layer 27. The third section 68A3 of the UBM layer 63 may be continuous to the outside of the second section 68A2 of the UBM layer 63. The second section 68A2 of the UBM layer 63 may be disposed between the first section 68A1 of the UBM layer 63 and the third section 68A3 of the UBM layer 63. The upper surfaces of the first section 68A1, the second section 68A2 and the third section 68A3 of the UBM layer 63 may be disposed at a level higher than the uppermost end of the third insulating layer 27.

In an embodiment, the upper surfaces of the first section 68A1, the second section 68A2 and the third section 68A3 of the UBM layer 63 may form substantially the same plane. The upper surfaces of the first section 68A1, the second section 68A2 and the third section 68A3 of the UBM layer 63 may be disposed at substantially the same level.

Referring to FIG. 4, the upper surface of the first section 68A1 of the UBM layer 63 may be disposed at substantially the same level as the upper surface of the third section 68A3 of the UBM layer 63. The distance between the upper surface of the first section 68A1 of the UBM layer 63 and a conductive pad 48 may be substantially the same as the distance between the upper surface of the third section 68A3 of the UBM layer 63 and the conductive pad 48.

The upper surface of the second section 68A2 of the UBM layer 63 may include a concave area 68C. In an embodiment, the UBM layer 63 may be formed using an electrolytic plating method. A process of forming the UBM layer 63 may include forming a nickel (Ni) layer at a substantially uniform ratio along the surfaces of a second seed layer 54' and a protruding pattern 57. The nickel layer formed by electrolytic plating may be formed along a surface profile. The concave area 68C may be formed in correspondence to the height difference of the surfaces of the second seed layer 54' and the protruding pattern 57.

A through hole 27H may pass through the third insulating layer 27 in the vertical direction VD. The third section 68A3 of the UBM layer 63 may be defined as an area that overlaps the third insulating layer 27. The first section 68A1 of the UBM layer 63 may be defined as an area that overlaps the protruding pattern 57. The second section 68A2 of the UBM layer 63 may be delimited between the first section 68A1 and the third section 68A3. The second section 68A2 of the UBM layer 63 does not overlap the third insulating layer 27 and the protruding pattern 57. The concave area 68C may be formed at the middle of the second section 68A2 of the UBM layer 63. The concave area 68C may overlap the middle between the third insulating layer 27 and the protruding pattern 57. The distance between the bottom of the concave area 68C and the conductive pad 48 may be smaller than the distance between the uppermost end of the third section 68A3 of the UBM layer 63 and the conductive pad 48. The distance between the bottom of the concave area 68C and the conductive pad 48 may be smaller than the distance between the uppermost end of the first section 68A1 of the UBM layer 63 and the conductive pad 48.

A capping layer 65 may conformally cover the UBM layer 63. An undercut area UC1 may be disposed between the third insulating layer 27 and the UBM layer 63. A second barrier layer 53' and the second seed layer 54' may have a horizontal width narrower than the UBM layer 63. The horizontal width of the UBM layer 63 is W3'. Each of the horizontal width of the second barrier layer 53' and the horizontal width of the second seed layer 54' is W4'. W4' is smaller than the W3',

Referring to FIG. 5 and FIG. 6, the protruding pattern 57' may have a circular pillar shape. A UBM layer 63 may cover the protruding pattern 57' and fill the through hole 27H. Similar to the description with reference to FIG. 4, the upper surface of the UBM layer 63 may include a concave area 68C that is formed in correspondence to the height difference of the surfaces of a second seed layer 54 and the protruding pattern 57'. The concave area 68C may be aligned along the space between a third insulating layer 27 and the protruding pattern 57'. The concave area 68C may be formed in a circular trench shape. In an embodiment, the concave area 68C may overlap the middle between the third insulating layer 27 and the protruding pattern 57'.

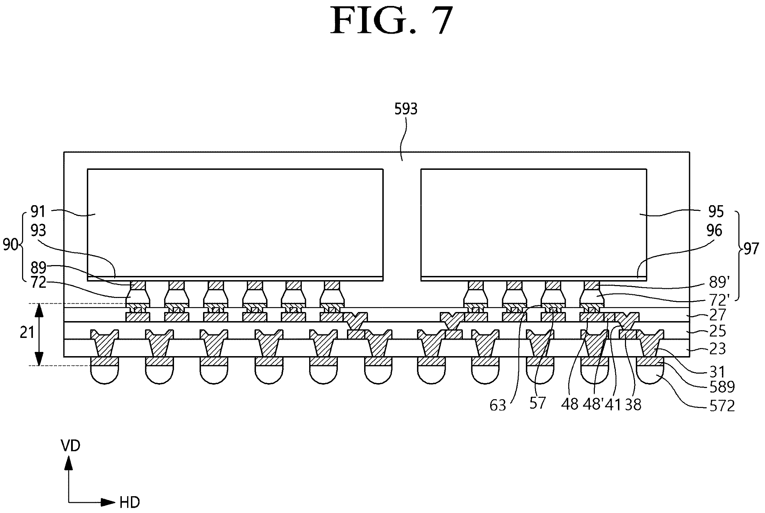

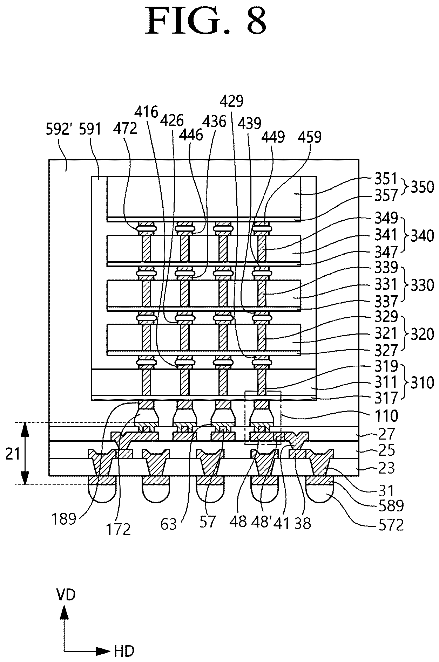

FIG. 7 and FIG. 8 are cross-sectional views illustrating semiconductor packages according to embodiments of the present disclosure.

Referring to FIG. 7, a semiconductor package according to embodiments of the present disclosure may include a wiring structure 21, a first semiconductor chip 90, a second semiconductor chip 97, an external solder interconnection 572, an external electrode 589, and a encapsulation layer 593.

The first semiconductor chip 90 and the second semiconductor chip 97 may be mounted on the wiring structure 21. The second semiconductor chip 97 may include a different type of semiconductor chip from the first semiconductor chip 90. The second semiconductor chip 97 may include a fourth solder interconnection 72', a second chip electrode 89', a second substrate 95, and a second circuit layer 96. The second circuit layer 96 may be disposed on the lower surface of the second substrate 95. The second chip electrode 89' may be disposed on the second circuit layer 96. The fourth solder interconnection 72' may be disposed between a UBM layer 63 and the second chip electrode 89'. The encapsulation layer 593 may cover the wiring structure 21, the first semiconductor chip 90 and the second semiconductor chip 97.

Referring to FIG. 8, a semiconductor package according to embodiments of the present disclosure may include a wiring structure 21, a base chip 310, core chips 320, 330 and 340, a top chip 350, an external solder interconnection 572, a first encapsulation layer 591, and a second encapsulation layer 592'. A multi-chip package including the base chip 310, the core chips 320, 330 and 340, the top chip 350 and the first encapsulation layer 591 may be mounted on the wiring structure 21.

The base chip 310 may include a base chip electrode 189 that is disposed on a base circuit layer 317. A third solder interconnection 172 may be disposed between a UBM layer 63 and the base chip electrode 189. The second encapsulation layer 592' may cover the wiring structure 21, the base chip 310, the core chips 320, 330 and 340, the top chip 350 and the first encapsulation layer 591. The second encapsulation layer 592' may extend between the wiring structure 21 and the base chip 310. The second encapsulation layer 592' may directly contact the side surfaces of the UBM layer 63, the third solder interconnection 172 and the base chip electrode 189.

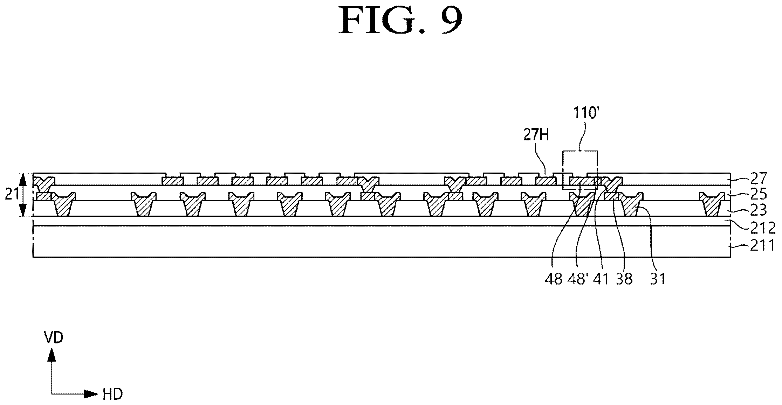

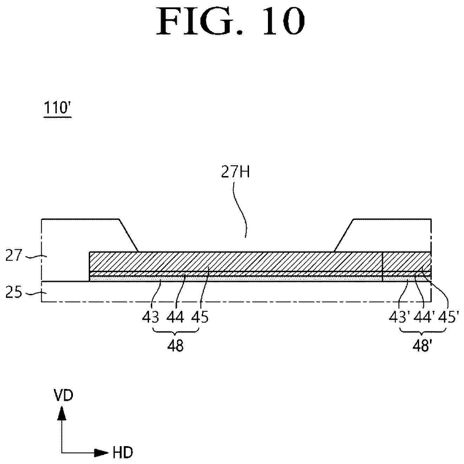

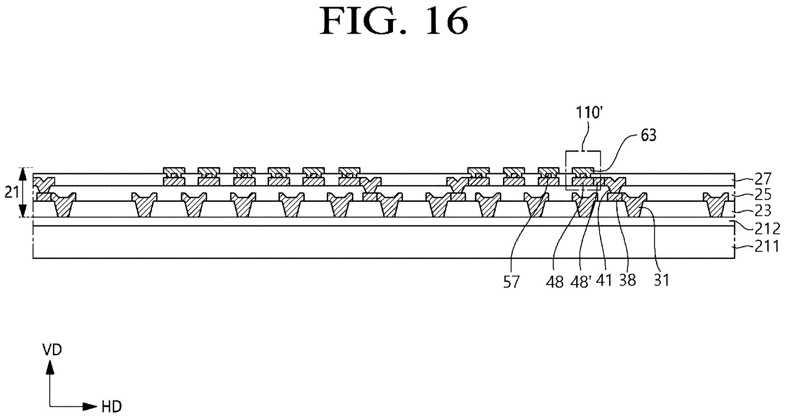

FIG. 9 and FIG. 16 to FIG. 19 are cross-sectional views illustrating a method of forming a semiconductor package according to embodiments of the present disclosure. FIG. 10 to FIG. 15 are partial cross-sectional views illustrating a part 110' of FIG. 9 and FIG. 16.

Referring to FIG. 9 and FIG. 10, a buffer layer 212 may be formed on a carrier substrate 211. A wiring structure 21 may be formed on the buffer layer 212. The wiring structure 21 may include a first insulating layer 23, a second insulating layer 25, a third insulating layer 27, a through hole 27H, a first via electrode 31, a first horizontal electrode 38, a second via electrode 41, a conductive pad 48, and a second horizontal electrode 48'. The conductive pad 48 and the second horizontal electrode 48' may include first barrier layers 43 and 43', first seed layers 44 and 44' and first conductive layers 45 and 45'.

The first insulating layer 23 may be formed on the buffer layer 212. The first via electrode 31 may penetrate the first insulating layer 23 in a vertical direction VD. The first horizontal electrode 38 may be formed on the first insulating layer 23. The first via electrode 31 may contact the side surface of the first horizontal electrode 38.

The second insulating layer 25 may cover the first insulating layer 23, the first via electrode 31 and the first horizontal electrode 38. The second via electrode 41 may penetrate the second insulating layer 25 in the vertical direction VD. The second via electrode 41 may contact the first horizontal electrode 38. The conductive pad 48 and the second horizontal electrode 48' may be formed on the second insulating layer 25. The second horizontal electrode 48' may contact the second via electrode 41. The conductive pad 48 may contact the side surface of the second horizontal electrode 48'.

The third insulating layer 27 may cover the second insulating layer 25, the second via electrode 41, the conductive pad 48 and the second horizontal electrode 48'. The through hole 27H may pass through the third insulating layer 27 in the vertical direction VD. The through hole 27H may overlap the conductive pad 48. The conductive pad 48 may be exposed at the bottom of the through hole 27H.

The carrier substrate 211 may include a glass wafer or a silicon wafer. The buffer layer 212 may include a release layer, an adhesive, or a combination thereof. Each of the first insulating layer 23, the second insulating layer 25 and the third insulating layer 27 may include polyimide (PI), polybenzoxazole (PBO), benzocyclobutene (BCB), polyhydroxystyrene (PHS), polyimide isoindolo quinazolinedione (PIQ), or a combination thereof.

In an embodiment, each of the first via electrode 31, the first horizontal electrode 38, the second via electrode 41, the conductive pad 48 and the second horizontal electrode 48' may be formed using an electrolytic plating method. Each of the first via electrode 31, the first horizontal electrode 38, the second via electrode 41, the conductive pad 48 and the second horizontal electrode 48' may include a copper layer.

In an embodiment, the conductive pad 48 and the second horizontal electrode 48' may include the first barrier layers 43 and 43', the first seed layers 44 and 44' on the first barrier layers 43 and 43' and the first conductive layer 45 and 45' on the first seed layers 44 and 44'. The first barrier layers 43 and 43' may include titanium (Ti), titanium nitride (TiN), tantalum (Ta), tantalum nitride (TaN), or a combination thereof. The first seed layers 44 and 44' may include a conductive material such as copper. The first seed layers 44 and 44' may be formed using a PVD method. The first conductive layers 45 and 45' may include copper layers. The first conductive layers 45 and 45' may be formed using an electrolytic plating method. In an embodiment, the electrolytic plating method may be advantageous in forming a copper layer with low electrical resistivity in a short period of time. In an embodiment, the thin film forming speed of the electrolytic plating method may be faster than a PVD method or a CVD method.

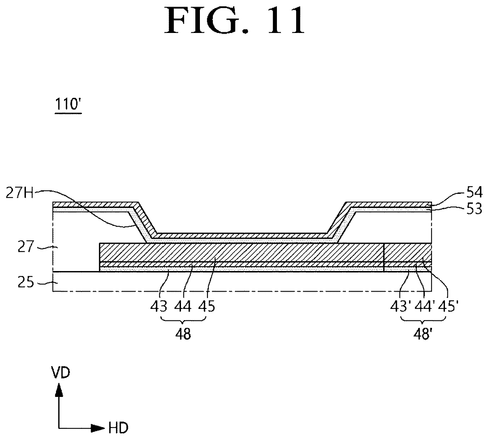

Referring to FIG. 11, a second barrier layer 53 may be formed on the third insulating layer 27. The second barrier layer 53 may conformally cover the inner wall of the through hole 27H. The second barrier layer 53 may contact the conductive pad 48. The second barrier layer 53 may contact the side surface and upper surface of the third insulating layer 27. The second barrier layer 53 may include titanium (Ti), titanium nitride (TiN), tantalum (Ta), tantalum nitride (TaN), or a combination thereof.

A second seed layer 54 may be formed on the second barrier layer 53. The second seed layer 54 may include a conductive material such as copper. In an embodiment, the second seed layer 54 may be omitted.

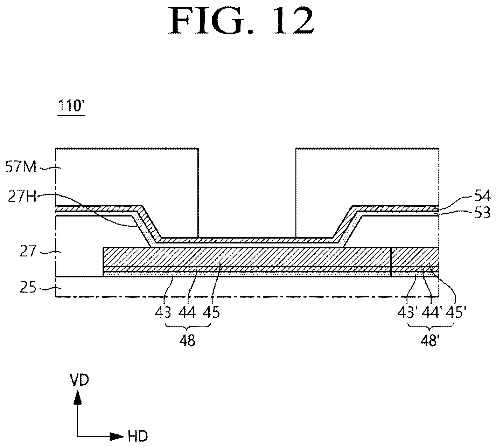

Referring to FIG. 12, a first mask pattern 57M may be formed on the second barrier layer 53 and the second seed layer 54. The first mask pattern 57M may cover the edge of the through hole 27H.

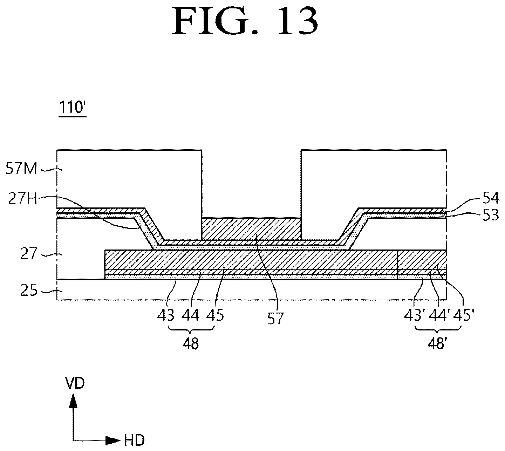

Referring to FIG. 13, a protruding pattern 57 may be formed on a portion of the second seed layer 54, which is not covered by the first mask pattern 57M. The space between the protruding pattern 57 and the sidewall of the through hole 27H may be covered with the first mask pattern 57M. The protruding pattern 57 may have a horizontal width smaller than the through hole 27H. The protruding pattern 57 may overlap the center of the through hole 27H. The uppermost surface of the protruding pattern 57 may be formed at substantially the same level as the uppermost surface of the third insulating layer 27 or at a level lower than the uppermost surface of the third insulating layer 27. In an embodiment, the protruding pattern 57 may include a copper layer. The protruding pattern 57 may be formed using an electrolytic plating method.

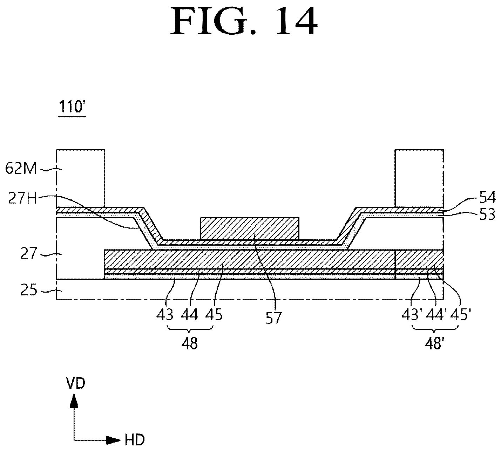

Referring to FIG. 14, a second mask pattern 62M may be formed on the second seed layer 54. The second mask pattern 62M may be formed after removing the first mask pattern 57M. Alternatively, the second mask pattern 62M may be formed by additionally processing the first mask pattern 57M. The second seed layer 54 may be exposed between the second mask pattern 62M and the protruding pattern 57.

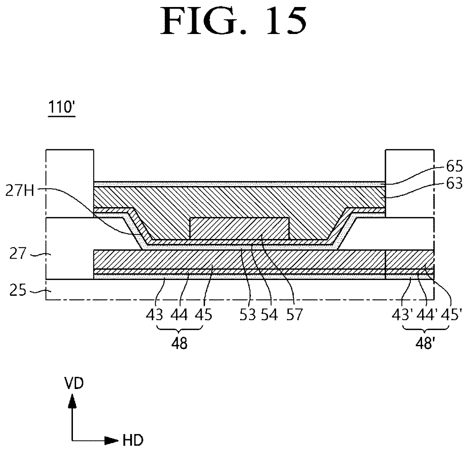

Referring to FIG. 15, a UBM layer 63 may be formed on the protruding pattern 57 and second seed layer 54, which is not covered by the second mask pattern 62M. The UBM layer 63 covers the protruding pattern 57 and fills the through hole 27H. A capping layer 65 may be formed on the UBM layer 63. In an embodiment, the UBM layer 63 may include a nickel (Ni) layer. The UBM layer 63 may be formed using an electrolytic plating method. The capping layer 65 may include a gold (Au) layer.

The UBM layer 63 may completely fill the through hole 27H. The UBM layer 63 may extend onto the third insulating layer 27. The UBM layer 63 may have a horizontal width larger than the through hole 27H. The UBM layer 63 may cover the side surface and upper surface of the protruding pattern 57. The UBM layer 63 may fill the space between the sidewall of the through hole 27H and the protruding pattern 57.

A process of forming the UBM layer 63 may include forming a plating layer at a substantially uniform ratio along the surface of an electrode. In an embodiment, a process of forming the UBM layer 63 may include forming a nickel (Ni) layer at a substantially uniform ratio along the surfaces of the second seed layer 54 and the protruding pattern 57. In an embodiment, because a nickel layer formed by electrolytic plating is formed along a surface profile, a nickel layer formed on a surface including the through hole 27H may have topographical variations corresponding to the shape of the through hole 27H. In an embodiment, when a solder interconnection is formed on the topographical variations corresponding to the shape of the through hole 27H, voids may be formed due to the topographical variations, which may weaken the coupling strength of the solder interconnection. In an embodiment, the protruding pattern 57 is configured to reduce topographical variations of the upper surface of the UBM layer. In an embodiment, the topographical variations of the UBM layer 63 may be minimized by the protruding pattern 57.

The capping layer 65 may cover the UBM layer 63. The capping layer 65 may have a thickness smaller than the UBM layer 63. The capping layer 65 may be omitted.

Referring to FIG. 16, by removing the second mask pattern 62M and partially removing the second barrier layer 53 and the second seed layer 54, the UBM layer 63 and the third insulating layer 27 may be exposed. The UBM layer 63 and the third insulating layer 27 may include various shapes as illustrated in FIG. 3 to FIG. 6.

In an embodiment, a process of removing the second barrier layer 53 and the second seed layer 54 to expose the third insulating layer 27 may include an etching process. As illustrated in FIG. 4, while the etching process is performed, the second barrier layer 53 and the second seed layer 54 may be over-etched, by which an undercut area UC1 may be formed between the third insulating layer 27 and the UBM layer 63.

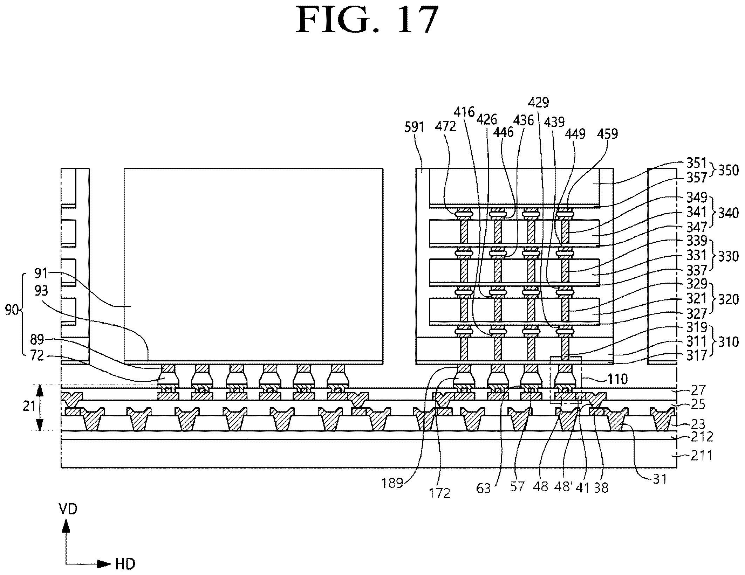

Referring to FIG. 17, a first semiconductor chip 90 may be mounted on the wiring structure 21. The first semiconductor chip 90 may include a first substrate 91 and a first circuit layer 93. A chip electrode 89 may be formed on the first circuit layer 93. A first solder interconnection 72 may be formed between the UBM layer 63 and the chip electrode 89.

A multi-chip package including a base chip 310, core chips 320, 330 and 340, a top chip 350 and a first encapsulation layer 591 may be mounted on the wiring structure 21. A base chip electrode 189 may be disposed on a base circuit layer 317 of the base chip 310. A third solder interconnection 172 may be formed between the UBM layer 63 and the base chip electrode 189.

Referring again to FIG. 2, FIG. 3 and FIG. 17, each of the chip electrode 89, the base chip electrode 189, a conductive pattern 313, a base through electrode 319, a first core through electrode 329, a second core through electrode 339, a third core through electrode 349, a base back electrode 416, a first core back electrode 426, a second core back electrode 436, a third core back electrode 446, a first core front electrode 429, a second core front electrode 439, a third core front electrode 449 and a top front electrode 459 may include metal, metal nitride, conductive carbon, or a combination thereof.

In an embodiment, a third barrier layer 83 may include titanium (Ti), titanium nitride (TiN), tantalum (Ta), tantalum nitride (TaN), or a combination thereof. A third seed layer 84 may include a conductive material such as copper. A second conductive layer 85 may include a pillar shape. The second conductive layer 85 may be formed using an electrolytic plating method. The second conductive layer 85 may include a copper layer. A third conductive layer 88 may be formed on the second conductive layer 85. The third conductive layer 88 may be formed using an electrolytic plating method. The third conductive layer 88 may include a nickel (Ni) layer.

Each of the first solder interconnection 72, the third solder interconnection 172 and a second solder interconnection 472 may include tin (Sn), silver (Ag), copper (Cu), bismuth (Bi), indium (In), zinc (Zn), gold (Au), palladium (Pd), antimony (Sb), or a combination thereof. A first intermetallic layer IM1 may include all of materials that form the third solder interconnection 172 and the UBM layer 63. In an embodiment, the first intermetallic layer IM1 may include all of materials that form the third solder interconnection 172, the UBM layer 63 and the capping layer 65 (see FIG. 15). A second intermetallic layer IM2 may include all of materials that form the third solder interconnection 172 and the third conductive layer 88.

Each of the first substrate 91, a base substrate 311, a first core substrate 321, a second core substrate 331, a third core substrate 341 and a top substrate 351 may include a semiconductor substrate such as a silicon wafer or a Silicon On Insulator (SOI) wafer. Each of the first substrate 91, the base substrate 311, the first core substrate 321, the second core substrate 331, the third core substrate 341 and the top substrate 351 may include a III-V group semiconductor substrate, for example, a compound semiconductor substrate such as gallium arsenide (GaAs). Each of the first substrate 91, the base substrate 311, the first core substrate 321, the second core substrate 331, the third core substrate 341 and the top substrate 351 may include monocrystalline silicon, polysilicon, amorphous silicon, monocrystalline silicon germanium, polycrystalline silicon germanium, carbon-doped silicon, or a combination thereof

The first encapsulation layer 591 may include an epoxy molding compound.

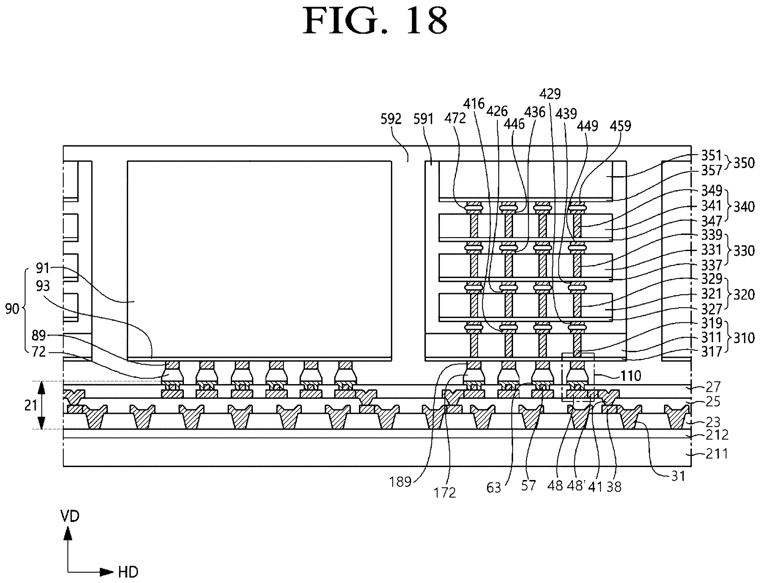

Referring to FIG. 18, a second encapsulation layer 592 that covers the wiring structure 21, the first semiconductor chip 90, the base chip 310, the core chips 320, 330 and 340, the top chip 350 and the first encapsulation layer 591 may be formed. The second encapsulation layer 592 may extend between the wiring structure 21 and the first semiconductor chip 90 and between the wiring structure 21 and the base chip 310. The second encapsulation layer 592 may include an epoxy molding compound.

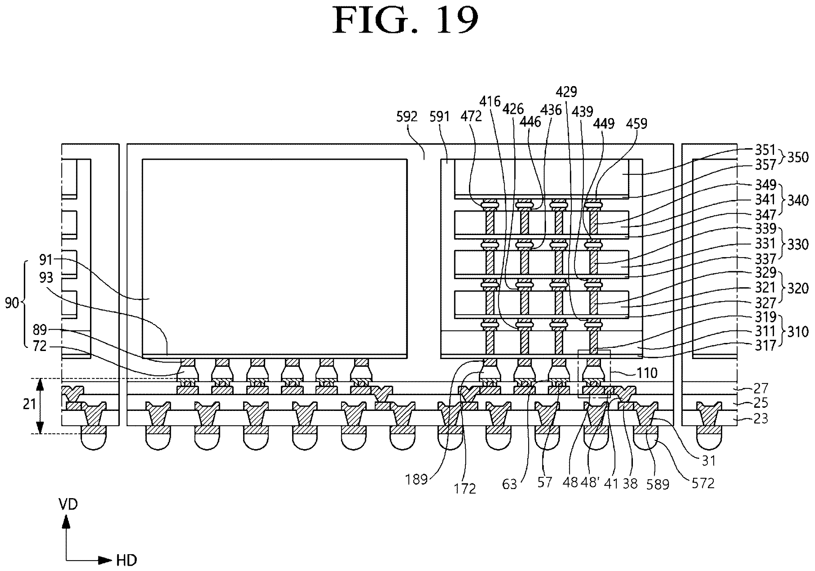

Referring to FIG. 19, the carrier substrate 211 and the buffer layer 212 may be removed. An external electrode 589 may be formed on the lower surface of the wiring structure 21. The external electrode 589 may contact the first via electrode 31. An external solder interconnection 572 may be formed on the external electrode 589. Semiconductor packages may be divided using a singulation process.
The external electrode 589 may include copper (Cu). The external solder interconnection 572 may include tin (Sn), silver (Ag), copper (Cu), bismuth (Bi), indium (In), zinc (Zn), gold (Au), palladium (Pd), antimony (Sb), or a combination thereof.
While the detailed embodiments of the present disclosure are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope.

## Claims

1. A semiconductor package comprising:
a wiring structure including a first insulating layer, a conductive pad on the first insulating layer, a second insulating layer on the conductive pad, a through hole passing through the second insulating layer and overlapping with the conductive pad, a protruding pattern disposed on the conductive pad and located in the through hole, and an under bump metallurgy (UBM) layer that contacts the upper surface and side surface of the protruding pattern and is connected to the conductive pad; and
a semiconductor chip disposed on the wiring structure and connected to the UBM layer.

2. The semiconductor package according to claim 1, wherein the protruding pattern has a horizontal width smaller than the through hole.

3. The semiconductor package according to claim 1, wherein the protruding pattern overlaps the center of the through hole.

4. The semiconductor package according to claim 1, wherein the uppermost surface of the protruding pattern is disposed at the same level as or a lower level than the uppermost surface of the second insulating layer.

5. The semiconductor package according to claim 1, wherein
the UBM layer includes a first section that overlaps the protruding pattern, a second section that overlaps a space between the second insulating layer, and a third section that overlaps the second insulating layer, and
the upper surfaces of the first section, the second section and the third section are disposed at a level higher than the uppermost surface of the second insulating layer.

6. The semiconductor package according to claim 5, wherein the upper surfaces of the first section, the second section and the third section form substantially the same plane.

7. The semiconductor package according to claim 5, wherein
the upper surface of the second section includes a concave area, and
the distance between the concave area and the conductive pad is smaller than the distance between the upper surface of the third section and the conductive pad.

8. The semiconductor package according to claim 5, wherein
the upper surface of the second section includes a concave area, and
the distance between the concave area and the conductive pad is smaller than the distance between the upper surface of the first section and the conductive pad.

9. The semiconductor package according to claim 5, wherein
the upper surface of the second section includes a concave area, and
the concave area overlaps the middle between the second insulating layer and the protruding pattern.

10. The semiconductor package according to claim 1, further comprising
a barrier layer disposed between the protruding pattern and the conductive pad, extending onto the conductive pad between the protruding pattern and the second insulating layer, and extending between the UBM layer and the second insulating layer,
wherein the barrier layer includes titanium (Ti), titanium nitride (TiN), tantalum (Ta), tantalum nitride (TaN), or a combination thereof.

11. The semiconductor package according to claim 10, further comprising
a seed layer between the protruding pattern and the barrier layer and between the UBM layer and the barrier layer,
wherein the seed layer includes a conductive material.

12. The semiconductor package according to claim 1, wherein the protruding pattern includes a copper (Cu) layer.

13. The semiconductor package according to claim 1, wherein the UBM layer includes a nickel (Ni) layer.

14. The semiconductor package according to claim 1, further comprising a solder interconnection between the UBM layer and the semiconductor chip, wherein the solder interconnection includes tin (Sn), silver (Ag), copper (Cu), bismuth (Bi), indium (In), zinc (Zn), gold (Au), palladium (Pd), antimony (Sb), or a combination thereof.

15. A semiconductor package comprising:
a wiring structure including a first insulating layer, a plurality of conductive pads on the first insulating layer, a second insulating layer on the plurality of conductive pads, a plurality of through holes that pass through the second insulating layer and respectively overlap the plurality of conductive pads, a plurality of protruding patterns respectively disposed on the plurality of conductive pads and respectively located in the plurality of through holes, and a plurality of under bump metallurgy (UBM) layers that respectively contact the upper surfaces and side surfaces of the plurality of protruding patterns and are connected to the plurality of conductive pads;
first and second semiconductor chips disposed on the wiring structure; and
an encapsulation layer disposed on the wiring structure and covering the first and second semiconductor chips.

16. The semiconductor package according to claim 15, further comprising
a plurality of solder interconnections disposed respectively between the plurality of UBM layers and the first semiconductor chip and between the plurality of UBM layers and the second semiconductor chip,
wherein the encapsulation layer extends between the wiring structure and the first semiconductor chip and between the wiring structure and the second semiconductor chip, and
wherein the encapsulation layer contacts the side surfaces of the plurality of UBM layers and the plurality of solder interconnections.

17. The semiconductor package according to claim 15, wherein
each of the plurality of UBM layers includes a first section that overlaps a corresponding one of the plurality of protruding patterns, a second section that overlaps a space between the second insulating layer and the corresponding one of the plurality of protruding patterns and does not overlap the second insulating layer, and a third section that overlaps the second insulating layer, and
the upper surfaces of the first section, the second section and the third section are disposed at a level higher than the uppermost surface of the second insulating layer.

18. The semiconductor package according to claim 17, wherein
the upper surface of the second section includes a concave area, and
the distance between the concave area and a corresponding one of the plurality of conductive pads is smaller than the distance between the upper surface of the third section and the corresponding one of the plurality of conductive pads.

19. The semiconductor package according to claim 17, wherein
the upper surface of the second section includes a concave area, and
the distance between the concave area and a corresponding one of the plurality of conductive pads is smaller than the distance between the upper surface of the first section and the corresponding one of the plurality of conductive pads.

20. A semiconductor package comprising:
a first insulating layer;
a conductive pad on the first insulating layer;
a second insulating layer on the conductive pad;
a through hole passing through the second insulating layer and overlapping the conductive pad;
a protruding pattern disposed on the conductive pad and located in the through hole and including a horizontal width smaller than the through hole;
a under bump metallurgy (UBM) layer contacting the upper surface and side surface of the protruding pattern and including a horizontal width larger than the through hole, the upper surface of the UBM layer including a concave area that overlaps a space between the protruding pattern and the second insulating layer; and
a semiconductor chip on the UBM layer.
